# EUROPEAN PATENT APPLICATION

(11) **EP 1 713 116 A1**
(43) Date of publication of application: **18.10.2006**
(21) Application number: 03781011.6
(22) Date of filing: 22.12.2003
(51) Int. Cl.: H01L 21/265, C30B 29/04

(54) **PROCESS FOR PRODUCING n-TYPE SEMICONDUCTOR DIAMOND AND n-TYPE SEMICONDUCTOR DIAMOND**

(30) Priority: 29.10.2003 JP 2003368198; 20.11.2003 JP 2003390035
(71) Applicant: Sumitomo Electric Industries, Ltd., Osaka-shi, Osaka 541-0041 (JP)
(72) Inventor: NAMBA, Akihiko, c/o Itami Works, Itami-shi, Hyogo 664-0016 (JP); YAMAMOTO, Yoshiyuki, c/o Itami Works, Itami-shi, Hyogo 664-0016 (JP); SUMIYA, Hitoshi, c/o Itami Works, Itami-shi, Hyogo 664-0016 (JP); NISHIBAYASHI, Yoshiki, c/o Itami Works, Itami-shi, Hyogo 664-0016 (JP); IMAI, Takahiro, c/o Itami Works, Itami-shi, Hyogo 664-0016 (JP)
(74) Representative: Cross, Rupert Edward Blount
(86) International application number: PCT/JP2003/016493
(87) International publication number: WO 2005/041279

(57) **Abstract**

A method of manufacturing *n*-type semiconductor diamond by the present invention is **characterized in** producing diamond incorporating *Li* and *N* by implanting *Li* ions into, so that 10 ppm thereof will be contained in, single-crystal diamond incorporating 10 ppm or more *N*, or else, in doping single-crystal diamond with *Li* and *N* ions, by implanting the ions so that ion-implantation depths at which the post-implantation *Li* and *N* concentrations each are 10 ppm or more will overlap, and thereafter annealing the diamond in a temperature range of from 800°C or more to less than 1800°C to electrically activate the *Li* and *N* and restore the diamond crystalline structure. In the present invention, *n*-type semiconductor diamond incorporates, from the surface of the crystal to the same depth, 10 ppm or more of each of *Li* and *N,* wherein its sheet resistance is 10⁷ Ω/□ or less.

## Description

### Technical Field

The present invention relates to methods of manufacturing *n*-type semiconductor diamond by ion implantation, and to low-resistivity *n*-type semiconductor diamond. The invention relates in particular to a method of using ion implantation to produce low-resistivity *n*-type semiconductor diamond incorporating lithium (Li) and nitrogen (N), and to a method of annealing diamond in which recovery from radiation damage following ion implantation takes place.

### Background Art

Because diamond is composed of silicon (Si), which is widely used in semiconductor materials, and carbon (C), which is a Group IVb element in the same family as silicon, and because it possesses the same crystalline structure as Si, diamond may be regarded as a semiconductor material. In terms of being a semiconductor material diamond has an extraordinarily large bandgap of 5.5 eV, and a high carrier mobility of 2000 cm²/ *V* · s for electrons/holes alike at room temperature. And with its dielectric constant being a small 5.7, its breakdown electric field is a large 5 × 10⁶ Wcm. Diamond also has the unusual property of negative electron affinity, in that its vacuum level is present below the lower edge of its conduction band.

Inasmuch as diamond thus has outstanding semiconductor properties, its practical application is being counted on as a material for semiconductor devices such as harsh-environment-withstanding devices that operate under high-temperature environments and outer-space environments; power devices that can operate at high frequency and with high-output; light-emitting devices capable of emitting ultraviolet light; and electron emitters that can be driven at low voltage.

In order to employ a semiconductor material as a semiconductor device, it must be controlled to have *n*-type or *p*-type electroconductivity. Such manipulation is carried out by doping the semiconductor material with impurities. If the material is Si, for example, doping phosphorous (P) into single-crystal Si will make the material *n*-type, while doping it with boron (B) will make it *p*-type.

Doping techniques for this adding of impurities include, as typifying examples: (a) processes that dope by adding element impurities during growth of the crystal; (b) the thermal diffusion method, in which impurities are doped by diffusing them through the crystal surface; and (c) the ion implantation method, in which accelerated impurity ions are implanted through the crystal surface.

The ion implantation method is among these currently the mainstream process for doping semiconductors because it possesses superior features, such as: 1) allowing the volume of impurity added and the addition depth to be controlled; 2) if used in conjunction with photoresist, enabling the doping regions to be controlled; 3) less lateral spread of impurities compared with thermal diffusion. Nevertheless, since destruction of the crystalline structure occurs when impurity ions are implanted into a crystal, in order to restore the crystalline structure and electrically activate the impurities, heat treatment (annealing) and associated operations after ion implantation must be included in the procedure.

In that diamond possesses exceptionally fine semiconductor properties, the creation of semiconductor diamond by ion implantation has been attempted. With regard to *p*-type semiconductor diamond, a technique is disclosed in Physical Review B, Vol. 38, No. 8, (1988), p. 5576, in which, given the temperature dependency of the behavior within diamond crystal of vacancies and interstitial atoms produced by ion implantation, ions are implanted into diamond cooled to the temperature of liquid nitrogen, and then the diamond temperature is rapidly elevated, whereby the radiation damage is repaired with the diamond structure kept intact. As a result, a 0.37 eV activation energy, which is the same as the activation energy of boron-doped semiconductor diamond produced in nature, was achieved for the first time with diamond into which boron ions were implanted. This technique is called "CIRA" (cold implantation and rapid annealing); it is also disclosed in Japanese Unexamined Pat. App. Pub. No. H06-166594.

Following that, any number of improvements have been added to CIRA―for example, the creation of ion-implantation, *B*-doped *p*-type diamond of 6 × 10¹³ cm⁻³ acceptor concentration and 385 cm²/ *V* · s carrier mobility by a Hall-effect measurement at 300 K is reported in Appl. Phys. Lett., Vol. 68, No. 16, (1996), p. 2264. With these values comparing favorably even to those for *B*-doped *p*-type epitaxial semiconductor diamond, the creation of *p*-type semiconductor diamond utilizing the ion implantation process is becoming possible by means of CIRA.

With regard to *n*-type semiconductor diamond, however, although numerous experiments to implant an *n*-type dopant such as phosphorous (P), sulfur (S), or lithium (Li) have been conducted, outstanding successes have not been reported. For example, although in *Diamond and Related Materials 8,* (1999), p. 1635 it is reported that a 0.6 eV activation energy―the same as that of *P*-doped, *n*-type homoepitaxial semiconductor diamond―was achieved by means of *P-*ion implantation, the sheet resistance of the diamond at 350°C is a very high 10¹² Ω/□.

Then again, a technique with which *n*-type semiconductor is obtained by implanting diamond with a Group V element is proposed in Japanese Unexamined Pat. App. Pub. No. H11-100296. Likewise, proposed in Japanese Unexamined Pat. App. Pub. No. H05-024991 is a method of doing the annealing using a laser beam, and in Japanese Unexamined Pat. App. Pub. No. H06-048715 is a method of irradiating diamond with ultraviolet rays to repair radiation damage therein and to activate its dopant. Nevertheless, in either case the methods are distinguished only in that thermal energy necessary to recover the diamond from defects is applied; with no account regarding the resistance values being given, the presumption is that the same extraordinarily high resistance as with Diamond and Related Materials 8, (1999), p. 1635 would be the case.

Accordingly, as far as the creation of semiconductor diamond using ion implantation is concerned, although there has been success in producing *p*-type, there has not been success in producing low-resistivity *n*-type. This has thus hindered the broad practical application in electronic devices of diamond having superior semiconductor properties.

### Disclosure of Invention

An object of the present invention, which has been brought about to resolve the foregoing problems, is to make available a method of manufacturing low-resistivity *n*-type semiconductor diamond by the ion implantation method. More specifically, an object is to make available a technique that yields *n*-type semiconductor diamond by implanting a predetermined quantity of *Li* ions into a single-crystal diamond incorporating a predetermined quantity of *N,* or else implanting *Li* and *N* ions each at a predetermined energy and dose into a single-crystal diamond essentially not containing impurities, and thereafter annealing the diamond within a predetermined temperature range.

Another object is, in a technique that implants *Li* and *N* each at a predetermined energy and dose to yield *n*-type semiconductor diamond, as well as in the repair of radiation damage due to ion implantation, to make available a method that utilizes pressure-temperature conditions under which diamond will exist stably, and to afford low-resistivity *n*-type semiconductor diamond containing *LI* and *N.*

A method of manufacturing *n*-type semiconductor diamond by the present invention is characterized in producing diamond incorporating *Li* and *N* by implanting *Li* ions into, so that 10 ppm thereof will be contained in, single-crystal diamond incorporating 10 ppm or more *N*, and thereafter annealing the diamond in a temperature range of from 800°C or more to less than 1800°C to electrically activate the *Li* and *N* and restore the diamond crystalline structure.

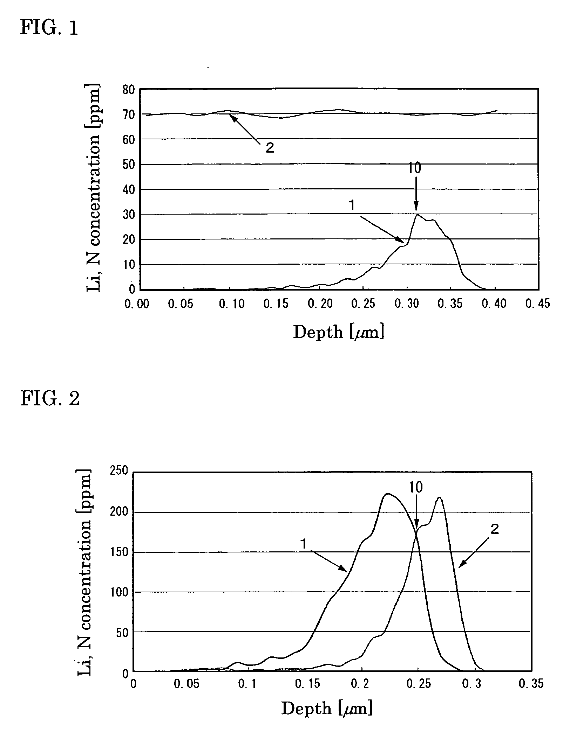

A method of manufacturing *n*-type semiconductor diamond by the present invention in another aspect is characterized in that, in implanting *Li* and *N* ions that are *n*-type dopants into single-crystal diamond essentially not containing impurities, the ions are implanted so that ion-implantation depths at which the post-implantation *Li* and *N* concentrations each are 10 ppm or more will overlap, and thereafter the diamond is annealed in a temperature range of from 800°C or more to less than 1800°C, electrically activating the *Li* and *N* and restoring the diamond crystalline structure. The overlapping of the ion-implantation depths at which the *Li* and *N* concentrations each are 10 ppm or more is, with reference to Fig. 2 for example, the ion-implantation depths at which the *Li* concentration 1 is 10 ppm or more, which are 0.11 to 0.28 µm, and the ion-implantation depths at which the *N* concentration 2 is 10 ppm or more, which are 0.19 to 0.30 µm. Accordingly, in the 0.19 to 0.28 µm ion-implantation depth range, the *Li* and *N* concentrations each are 10 ppm or more. At the maximum value 10 in the overlap, the ion-implantation depth is 0.25 µm and the concentration is 170 ppm.

A separate method of manufacturing *n*-type semiconductor diamond by the present invention in another aspect is characterized in that, in implanting the *Li* and *N* ions as *n*-type dopants into single-crystal diamond, the ions are implanted so that ion-implantation depths at which the post-implantation *Li* and *N* concentrations each are 10 ppm or more will overlap, and so that the *Li* and *N* sum-total dose is 5.0 × 10¹⁵ cm⁻² or less.

Furthermore, in implanting the *Li* and *N* ions, preferably an ion-implantation apparatus having an electron-beam line and two ion-beam lines is utilized to implant the *Li* and *N* ions simultaneously while radiating with the electron beam the single-crystal diamond that is ion-implanted.

A method of manufacturing *n*-type semiconductor diamond by the present invention in another aspect is characterized in that in a step of restoring the crystalline structure of diamond in which post-implantation radiation damage remains and activating the dopants, annealing is done in a temperature range of from 800°C or more to less than 1800°C, under high-pressure conditions of 3 GPa or more.

In addition, *n*-type semiconductor diamond of the present invention is *Li-*and *N*-incorporating single-crystal diamond produced by the ion implantation process, and incorporates, from a face of the crystal to the same depth, 10 ppm or more of each of *Li* and *N*, wherein its sheet resistance is 10⁷ Ω/□ or less. The sheet resistance of *n*-type semiconductor diamond produced by an aforementioned manufacturing method is 10⁷ Ω/□ or less, which is a workable resistance value.

### Brief Description of Drawings

Fig. 1 is depthwise concentration profiles of *Li* and *N* in Sample No. 1 of Embodiment 1.
Fig. 2 is depthwise concentration profiles of *Li* and *N* in Sample No. 23 of Embodiment 2.
Fig. 3 is depthwise concentration profiles of *Li* and *N* in Sample No. 46 of Embodiment 3.
Fig. 4 is depthwise concentration profiles of *Li* and *N* in Sample No. 47 of Embodiment 3.
Fig. 5 is depthwise concentration profiles of *Li* and *N* in Sample No. 54 of Embodiment 3.

### Best Mode for Carrying Out the Invention

The fact that conventional *n*-type semiconductor diamond implanted with *P* or *S* ions turns out to be high-resistivity despite being annealed is thought to be because along with restoration of the diamond's crystallinity, vacancies that are generated during ion implantation associate with *n*-type dopants, and the *n*-type dopants end up becoming electrically inactivated.

The inventors conducted concerted research for the devising of an ion-implantation process in which despite annealing being carried out *n*-type dopants would not become associated with vacancies and thus would be electrically activated. As a result, they discovered that *Li* ions should be implanted into, so that 10 ppm or more are included in, a single-crystal diamond incorporating *N.* Thinking likewise, they discovered that alternatively, *Li* and *N* ions may be implanted into a single-crystal diamond essentially not incorporating impurities, with the ions being implanted so that the ion-implantation depths at which the post-implantation *Li* and *N* concentrations each are 10 ppm or more overlap.

They also discovered that *Li* and *N* ions may be implanted into single-crystal diamond, with the ions being implanted so that the ion-implantation depths at which the post-implantation *Li* and *N* concentrations each are 10 ppm or more overlap, and so that the *Li* and *N* sum-total dose is 5.0 × 10¹⁵ cm⁻² or less.

*Li* is an *n*-type dopant that, present interstitially with diamond crystal, becomes a donor. The fact that there are no reports of the formation of low-resistivity *n*-type semiconductor diamond by means of *Li*-ion implantation is because when the annealing process that enables the diamond's crystallinity to be restored is carried out, at the same time the crystallinity is restored, the *Li* and vacancies associate, rendering the *Li* electrically inactive. Consequently, the resistivity of the *n*-type semiconductor diamond into which *Li* ions have been implanted turns out high.

*N* is an *n*-type dopant that, taking up carbon-atom substitutional sites within diamond crystal, becomes a donor. Diamond containing *N* exists in nature, while the artificial composition of diamond by high-pressure, high-temperature synthesis is also possible. Nevertheless, with the donor level of *N*―approximately 1.7 eV―being with respect to diamond's 5.5 eV bandgap in a very deep position, at room temperature *N* does not for the most part become activated, wherein the resistivity is high.

*Li* and *N* readily combine with each other, as is the case with Li₃N (lithium nitride) existing as a stable nitrogen compound of *Li.* The inventors investigated the practical application of such qualities of *Li* and *N* to the *n*-type doping of diamond by the ion implantation method.

What they discovered as a result is that with single-crystal diamond, if *Li* ions alone are implanted into an *N*-incorporating single-crystal diamond so that it incorporates, from the surface of the crystal to the same depth, 10 ppm or more of each of *Li* and *N,* or else *Li* and *N* ions are implanted into a single-crystal diamond essentially not containing impurities, then as the annealing process is taking place, sooner than *Li* associates with vacancies, *Li* and *N* pairing occurs, and the *Li-N* pairs do not associate with vacancies but instead become electrically activated shallow donors.

They also discovered that if *Li* and *N* ions are implanted so that the ion-implantation depths at which the post-implantation *Li* and *N* concentrations each are 10 ppm or more overlap, and so that the *Li* and *N* sum-total dose is 5.0 × 10¹⁵ cm⁻² or less, then during the course of the annealing process, sooner than *Li* associates with vacancies, *Li* and *N* pairing occurs, and the *Li*-*N* pairs do not associate with vacancies but instead become electrically activated shallow donors.

With single-crystal diamond, if *Li* and *N* are implanted so that 10 ppm or more of each is not incorporated from the crystal surface to the same depth, then in annealing, the probability that pairing of *Li* and *N* will occur will be extremely low, and therefore with *Li* and *N* not becoming electrically activated, the resistivity will be high.

Furthermore, in order to get the *Li* and *N* ions to pair efficiently, preferably an ion-implantation apparatus having two ion-beam lines and an electron-beam line is utilized to implant the *Li* and *N* ions simultaneously while radiating with the electron beam the single-crystal diamond on which ion implantation is carried out. The inventors discovered that due to ion implantation, an atomic-level phenomenon in which implanted ions lose their energy while colliding with carbon atoms within the diamond crystal occurs at identical times with *Li* and with *N,* and that the supplying of electrons by the electron beam to the crystal surface of the single-crystal diamond on which ion implantation is carried out makes it so that *Li* and *N* distribute in locations within the single-crystal diamond in which pairing is likely to occur.

In addition, annealing conditions under which, at the same time diamond crystallinity is recovering itself, *Li* and *N* pairing occurs efficiently were probed. It was discovered as a result that annealing should be done in a temperature range of from 800°C or more to less than 1800°C.

It was also discovered that even in a case in which a dose of ions is implanted that is greater than the dose―specifically 5.0 × 10¹⁵ cm⁻²―that would be prohibitive of repairing radiation damage with annealing that has been known to date, annealing under a pressure of 3 GPa or more, at which diamond is stable, and at temperature in a range of 800°C or more but less than 1800°C repairs the diamond crystallinity and also electrically activates the dopant.

If the annealing conditions fall outside the parameters of 800°C or more but less than 1800°C, restoration of the diamond crystallinity cannot be effected completely.

Any of a number of techniques, including electric-furnace heating, infrared radiation, ultraviolet radiation, and laser radiation may be utilized as a way to do the annealing, that is, as the means of repairing post-implantation radiation damage and electrically activating the dopant.

Likewise, if the annealing conditions fall outside the parameters of 800°C or more but less than 1800°C, and of 3 GPa or more, in a case in which a dose is implanted that would be prohibitive of repairing radiation damage with annealing, restoration of the diamond crystallinity cannot go through completely, or even though restoration can go through, the *Li* and *N* cluster in numbers, becoming electrically inactive. On the other hand, to carry out annealing at a pressure in excess of 8 GPa, would necessitate special ultrahigh-pressure, high-temperature generating equipment, which from a cost and productivity perspective would be disadvantageous. A further advantage to annealing according to the present invention is that it is practicable for radiation damage repair and electrical activation in cases in which ions such as *N* by itself, or *P, S, As, Cl, Se, Na, Kor Br* are implanted.

As set forth above, a method of manufacturing *n*-type semiconductor diamond by the present invention makes it possible to achieve low-resistivity *n*-type semiconductor diamond incorporating, from the surface of the crystal to the same depth, 10 ppm or more of each of *Li* and *N*, wherein the diamond's sheet resistance is 10⁷ Ω/□ or less.

### Embodiment 1

For implanting *Li* ions, an ion-implanter whose maximum acceleration voltage is 400 kV was utilized, and as the single-crystal diamond for ion implantation, a high-pressure/high-temperature synthesized type-I*b* single-crystal diamond whose (100) plane measured 2 mm × 2 mm, and whose thickness was 0.3 mm was utilized. The temperature during implantation was set at room temperature, and the implant tilt for preventing channeling of the implantation ions was set at 7°.

As to post-implantation annealing, the process was performed under reduced-pressure and under high-pressure conditions. For the annealing process under reduced pressure, the samples were put into an infrared-radiation annealing oven, and then the oven pressure was reduced to a predetermined level, following which the samples were heated up to a predetermined temperature. The anneal time was 30 minutes. For the annealing process under high pressure, an ultrahigh-pressure generator was employed to pressurize the samples to a predetermined level, following which they were heated up to a predetermined temperature. The annealing time was 10 hours. It is to be noted that as to the pressure conditions in the high-pressure test, at less than 3 GPa, restoration of crystallinity did not take place, and because pressure in excess of 8 GPa necessitates special ultrahigh-pressure generating equipment, which cost and productivity considerations would rule out, annealing was carried out within a prerequisite range of 3 GPa or more but 8 GPa or less. The testing parameters are set forth in Table I. In Table I, the "keV" column indicates implantation energy, and the "cm⁻²" column, implantation dose.

Evaluation of the ion-implant diamond produced in this way was performed as follows. Evaluation of crystallinity was made by Raman spectral analysis, evaluation of electrical characteristics, by Hall-effect measurement using the Van der Pauw method, and profiles of *Li* and *N* concentrations within the diamond crystal, by secondary-ion mass spectroscopy (SIMS).

With the Raman spectral analysis, crystallinity was evaluated according to the presence/absence of the 1333 cm⁻¹ peak that arises in diamond, and the peak that is exhibited at 1500 cm⁻¹ to 1600 cm⁻¹, arising in graphite. In Table I, the presence/absence of a 1333 cm⁻¹ peak is indicated in the "D" column, the presence/absence of a 1500 cm⁻¹ to 1600 cm⁻¹ peak, in the "G" column. Crystals for which there is no peak arising in graphite, and only the peak arising in diamond were those whose crystallinity is favorable.

With the Hall-effect measurement, the carrier type in, and sheet resistance of, the samples was evaluated at room temperature (27°C). For electrodes in making the measurements, ohmic contacts were created by first forming regions 200 µm in diameter in four corners of the samples by Ar-ion implantation to graphitize them depthwise from the deepest portion of the *Li* and *N* implantation layer up through to the episurface, so that electrical contact with the *Li* and *N* implantation layer could be established through the episurface, then with an electron beam vapor-depositing on the graphitized regions 100 nm of *Ti,* of *Pt,* and of *Au* respectively in that order, and annealing the samples 20 minutes at 400°C.

With the SIMS, the depthwise concentration profile of *N* contained in the sample substrates, and of *Li* were measured. The depthwise concentration profiles for Sample No. 1 in Table I are graphed in Fig. 1. Further, the *N* concentration (ppm) contained in the single-crystal diamond utilized, and the implant peak concentration (ppm) in the depthwise concentration profile of *Li* are set forth in Table I.

**Table I**

| No. | Testing parameters | | | | | Evaluation results | | | | | |
|---|---|---|---|---|---|---|---|---|---|---|---|
| | *N* conc (ppm) | *Li* | | Annealing | | Implant peak | | Raman | | Hall meas. | |
| | | keV | cm⁻² | Press. (Pa) | Temp. (°C) | Depth | Conc. | D | G | Type | Ω/□ |
| 1 | 70 | 100 | 4×10¹³ | 1.3×10⁻⁴ | 800 | 0.31 | 30 | Yes | No | *n* | 4.2×10⁶ |
| 2 | 70 | 100 | 4×10¹³ | 1.3×10⁻⁴ | 1200 | 0.31 | 30 | Yes | No | *n* | 4.0×10⁶ |
| 3 | 70 | 100 | 4×10¹³ | 1.3×10⁻⁴ | 1750 | 0.31 | 30 | Yes | No | *n* | 3.7×10⁶ |
| 4 | 70 | 100 | 4×10¹³ | 4.0×10⁹ | 800 | 0.31 | 30 | Yes | No | *n* | 3.5×10⁶ |
| 5 | 70 | 100 | 4×10¹³ | 4.0×10⁹ | 1200 | 0.31 | 30 | Yes | No | *n* | 3.5×10⁶ |
| 6 | 70 | 100 | 4×10¹³ | 4.0×10⁹ | 1750 | 0.31 | 30 | Yes | No | *n* | 3.3×10⁶ |
| 7 | 15 | 100 | 2×10¹³ | 1.3×10⁻⁴ | 800 | 0.31 | 15 | Yes | No | *n* | 7.9×10⁶ |
| 8 | 15 | 100 | 2×10¹³ | 1.3×10⁻⁴ | 1200 | 0.31 | 15 | Yes | No | *n* | 7.6×10⁶ |
| 9 | 15 | 100 | 2×10¹³ | 1.3×10⁻⁴ | 1750 | 0.31 | 15 | Yes | No | *n* | 7.8×10⁶ |
| 10 | 15 | 100 | 2×10¹³ | 7.0×10⁹ | 800 | 0.31 | 15 | Yes | No | *n* | 7.4×10⁶ |
| 11 | 15 | 100 | 2×10¹³ | 7.0×10⁹ | 1200 | 0.31 | 15 | Yes | No | *n* | 7.2×10⁶ |
| 12 | 15 | 100 | 2×10¹³ | 7.0×10⁹ | 1750 | 0.31 | 15 | Yes | No | *n* | 7.2×10⁶ |
| 13 | 70 | 100 | 4×10¹³ | 1.3×10⁻⁴ | 750 | 0.31 | 30 | Yes | No | - | - |
| 14 | 70 | 100 | 4×10¹³ | 1.3×10⁻⁴ | 1800 | 0.31 | 30 | Yes | Yes | - | - |
| 15 | 70 | 100 | 4×10¹³ | 4.0×10⁹ | 750 | 0.31 | 30 | Yes | Yes | - | - |
| 16 | 70 | 100 | 4×10¹³ | 4.0×10⁹ | 1800 | 0.31 | 30 | Yes | Yes | - | - |
| 17 | 15 | 100 | 2×10¹³ | 1.3×10⁻⁴ | 750 | 0.31 | 15 | Yes | Yes | - | - |
| 18 | 15 | 100 | 2×10¹³ | 1.3×10⁻⁴ | 1800 | 0.31 | 15 | Yes | Yes | - | - |
| 19 | 15 | 100 | 2×10¹³ | 7.0×10⁹ | 750 | 0.31 | 15 | Yes | Yes | - | - |
| 20 | 15 | 100 | 2×10¹³ | 7.0×10⁹ | 1800 | 0.31 | 15 | Yes | Yes | - | - |
| 21 | 70 | 100 | 1×10¹³ | 1.3×10⁻⁴ | 1200 | 0.31 | 7 | Yes | No | *n* | 2.8×10⁷ |
| 22 | 8 | 100 | 2×10¹³ | 1.3×10⁻⁴ | 1200 | 0.31 | 15 | Yes | No | *n* | 3.5×10⁷ |

From Table I it may be ascertained that in the instances in which *Li* ions were implanted so that 10 ppm or more would be contained in single-crystal diamond incorporating 10 ppm or more *N,* and then the diamond was annealed at a temperature within a range of from 800°C or more to less than 1800°C to electrically activate the *Li* and *N* and restore the diamond crystalline structure, low-resistivity *n*-type semiconductor diamond was formed.

In contrast, in the instances in which the temperature parameter in annealing fell outside the temperature range of from 800°C or more to less than 1800°C, the diamond's crystallinity was not restored completely and graphite components remained, wherein Hall-effect measurements could not be made. In turn, in samples in which the concentration of Ncontained in the single-crystal diamond substrate was less than 10 ppm, or in which the lithium inclusion amount was less than 10 ppm, although the carrier type could be verified as *n*, the sheet resistance was larger than 1.0 × 10⁷ Ω/□, meaning that a workable resistance could not be achieved.

### Comparative Example 1

Test samples and evaluations were made along the lines of Embodiment 1, except that *Ar* was made the ion species implanted into the type I*b* single-crystal diamond, the implantation energy was made 300 keV and the dose, 1.0 × 10¹⁴ cm⁻², and further, the annealing parameters were rendered: pressure, 1.3 × 10⁻⁴ Pa; temperature, 1200°C. This led to 70 ppm *N* being contained in the single-crystal diamond, with the depth of the *Ar* implantation peak being 0.17 µm and its concentration being 90 ppm. In the Raman spectral analysis only the 1333 cm⁻¹ peak appeared, confirming that the diamond's crystallinity was restored. Nevertheless, in the Hall-effect measurement, the sheet resistance was an extraordinarily high 1.0 × 10¹⁴ Ω/□, or greater, meaning that the carrier type could not be determined.

### Embodiment 2

This embodiment was implemented like Embodiment 1, except that the single-crystal diamond for *Li* and *N* implantation was made a high-pressure/high-temperature synthesized, high purity type-II*a* single-crystal diamond whose (100) plane measured 2 mm × 2 mm, and whose thickness was 0.3 mm, and that *N* ions were also implanted. The evaluations were done likewise as with Embodiment 1, except that in the SIMS the depthwise concentration profiles of the *Li* and *N* were measured, and in the lapping portion the maximum concentration (ppm) and the depth (µm) at that value, along whichever profile was the lesser, were sought out. The depthwise concentration profile for sample No. 23 in Table II is graphed in Fig. 2. The *Li* and *N* implantation parameters and evaluation results are set forth in Table II.

**Table II**

| No. | Testing parameters | | | | | | Evaluation results | | | | | |
|---|---|---|---|---|---|---|---|---|---|---|---|---|
| | Li | | N | | Annealing | | Li & N overlap | | Raman | | Hall meas. (27°C) | |
| | keV | cm⁻² | keV | cm⁻² | Press. (Pa) | Temp. (°C) | Depth | Conc. | D | G | Type | Ω/□ |
| 23 | 60 | 3×10¹⁴ | 250 | 2×10¹⁴ | 1.3×10⁻⁴ | 800 | 0.25 | 170 | Yes | No | *n* | 1.7×10⁵ |
| 24 | 60 | 3×10¹⁴ | 250 | 2×10¹⁴ | 1.3×10⁻⁴ | 1200 | 0.25 | 170 | Yes | No | *n* | 1.5×10⁵ |
| 25 | 60 | 3×10¹⁴ | 250 | 2×10¹⁴ | 1.3×10⁻⁴ | 1750 | 0.25 | 170 | Yes | No | *n* | 1.5×10⁵ |
| 26 | 60 | 3×10¹⁴ | 250 | 2×10¹⁴ | 4.0×10⁹ | 800 | 0.25 | 170 | Yes | No | *n* | 1.2×10⁵ |
| 27 | 60 | 3×10¹⁴ | 250 | 2×10¹⁴ | 4.0×10⁹ | 1200 | 0.25 | 170 | Yes | No | *n* | 1.2×10⁵ |
| 28 | 60 | 3×10¹⁴ | 250 | 2×10¹⁴ | 4.0×10⁹ | 1750 | 0.25 | 170 | Yes | No | *n* | 1.1×10⁵ |
| 29 | 20 | 4×10¹³ | 20 | 2×10¹⁵ | 1.3×10⁴ | 800 | 0.06 | 15 | Yes | No | *n* | 8.8×10⁶ |
| 30 | 20 | 4×10¹³ | 20 | 2×10¹⁵ | 1.3×10⁻⁴ | 1200 | 0.06 | 15 | Yes | No | *n* | 8.6×10⁶ |
| 31 | 20 | 4×10¹³ | 20 | 2×10¹⁵ | 1.3×10⁻⁴ | 1750 | 0.06 | 15 | Yes | No | *n* | 8.5×10⁶ |
| 32 | 20 | 4×10¹³ | 20 | 2×10¹⁵ | 7.0×10⁹ | 800 | 0.06 | 15 | Yes | No | *n* | 8.5×10⁶ |
| 33 | 20 | 4×10¹³ | 20 | 2×10¹⁵ | 7.0×10⁹ | 1200 | 0.06 | 15 | Yes | No | *n* | 8.2×10⁶ |
| 34 | 20 | 4×10¹³ | 20 | 2×10¹⁵ | 7.0×10⁹ | 1750 | 0.06 | 15 | Yes | No | *n* | 8.4×10⁶ |
| 35 | 60 | 3×10¹⁴ | 250 | 2×10¹⁴ | 1.3×10⁻⁴ | 750 | 0.25 | 170 | Yes | Yes | - | - |
| 36 | 60 | 3×10¹⁴ | 250 | 2×10¹⁴ | 1.3×10⁻⁴ | 1800 | 0.25 | 170 | Yes | Yes | - | - |
| 37 | 60 | 3×10¹⁴ | 250 | 2×10¹⁴ | 4.0×10⁹ | 750 | 0.25 | 170 | Yes | Yes | - | - |
| 38 | 60 | 3×10¹⁴ | 250 | 2×10¹⁴ | 4.0×10⁹ | 1800 | 0.25 | 170 | Yes | Yes | - | - |
| 39 | 20 | 4×10¹³ | 20 | 2×10¹⁵ | 1.3×10⁻⁴ | 750 | 0.06 | 15 | Yes | Yes | - | - |
| 40 | 20 | 4×10¹³ | 20 | 2×10¹⁵ | 1.3×10⁻⁴ | 1800 | 0.06 | 15 | Yes | Yes | - | - |
| 41 | 20 | 4×10¹³ | 20 | 2×10¹⁵ | 7.0×10⁹ | 750 | 0.06 | 15 | Yes | Yes | - | - |
| 42 | 20 | 4×10¹³ | 20 | 2×10¹⁵ | 7.0×10⁹ | 1800 | 0.06 | 15 | Yes | Yes | - | - |
| 43 | 60 | 3×10¹⁴ | - | - | 1.3×10⁻⁴ | 1200 | - | - | Yes | No | *n* | 8.2×10¹¹ |
| 44 | - | - | 250 | 2×10¹⁴ | 1.3×10⁻⁴ | 1200 | - | - | Yes | No | - | 1×10¹⁴ or more |
| 45 | 150 | 5×10¹³ | 250 | 1×10¹⁴ | 1.3×10⁻⁴ | 1200 | 0.3 | 2 | Yes | No | *n* | 8.8×10⁹ |

From Table II it may be ascertained that in the instances in which, into a type-II*a* single-crystal diamond essentially not incorporating impurities, *Li* and Nions were implanted so that implantation depths at which the concentrations each were 10 ppm or more would overlap, and the diamond was annealed at a temperature in a range being 800°C or more but less than 1800°C, low-resistivity *n*-type semiconductor diamond was formed.

In contrast, in the instances in which either *Li* or *N* was implanted solo, and in which there was no lapping of regions where the *Li* and *N* concentrations each were 10 ppm or more, the sheet resistance was larger than 1.0 × 10⁷ Ω/□, meaning that a workable resistance could not be achieved. In turn, in the instances in which the temperature parameter in annealing fell outside the temperature range of from 800°C or more to less than 1800°C, the diamond's crystallinity was not restored completely and graphite components remained, wherein Hall-effect measurements could not be made.

### Comparative Example 2

*Li* and *Ar* ions were implanted in a manner similar to that of Embodiment 2, except that the *Li* was rendered in a 40 keV implantation energy and 2.0 × 10¹⁴ cm⁻² dose, and the *Ar* was rendered in a 300 keV implantation energy and 1.0 × 10¹⁴ cm⁻² dose, and further, the annealing parameters were put at: pressure, 1.3 × 10⁻⁴ Pa; temperature, 1200°C. The result was that in the concentration profiles for the *Li* and *Ar,* the lapping depth was 0.17 µm, where the concentration was 90 ppm. In the Raman spectral analysis only the 1333 cm⁻¹ peak appeared, confirming that the diamond's crystallinity was restored. Nevertheless, in the Hall-effect measurement, although it was determined that Comparative Example 2 was *n*-type, with its sheet resistance being an extraordinarily high 7.6 × 10¹¹ Ω/□, the example did not prove to be a practicable *n*-type semiconductor diamond.

### Embodiment 3

An implanter whose maximum acceleration voltage is 400 kV, capable of cooling to the temperature of liquid nitrogen (-196°C) and having a cooling/heating/implanting stage capable of ramping up from room temperature to 1400°C in approximately 10 seconds was utilized for the implantation of *Li* and *N* ions.

As the single-crystal diamond for ion implantation, a high-pressure/high-temperature synthesized type-I*b* single-crystal diamond whose (100) plane measured 2 mm × 2 mm and whose thickness was 0.3 mm, onto the (100) face of which high-quality undoped diamond was epitaxially grown in a 3 µm layer, was utilized. The implant tilt for preventing channeling of the implantation ions was set at 7°. In Table III, the "keV" column indicates implantation energy, and the "cm⁻²" column, implantation dose. For the annealing, CIRA was performed.

The temperature during implantation was -97°C, and the sequence in which the *Li* and *N* ions were implanted was made arbitrary. Following the *Li* and *N* implantation, the samples were heated up to 1050°C in 20 seconds, and in that state were annealed 10 minutes. Thereafter, the samples were taken out of the stage, and under a vacuum of 1.3 × 10⁻⁴ Pa (10⁻⁶ torr), underwent a 10-minute, 1450°C infrared-radiation anneal.

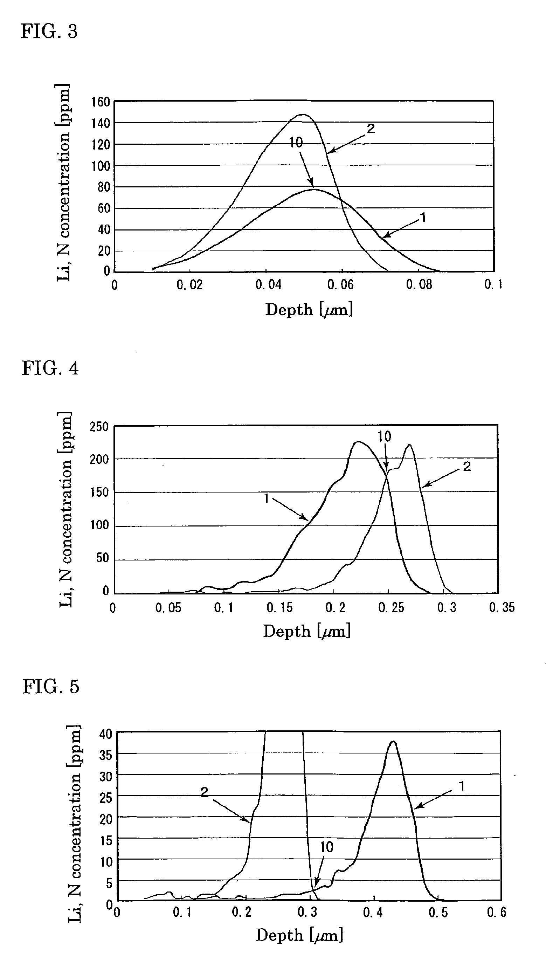

Evaluation of the ion-implant diamond produced in this way was carried out in the same way as in Embodiment 1. Here, the depthwise concentration profiles of the *Li* and *N* were measured using SIMS. Th depthwise concentration profiles for sample Nos. 46, 47 and 54 in Table III are graphed in Figs. 3, 4 and 5. Again, with the *Li* and *N* the depthwise concentration profiles, in the lapping portion the maximum concentration (ppm) and the depth (µm) at that value, along whichever profile was the lesser, are entered in Table III.

**Table III**

| No. | Implantation parameters | | | | Evaluation results | | | | | |
|---|---|---|---|---|---|---|---|---|---|---|
| | Li | | N | | Li & N overlap | | Raman | | Hall meas. | |
| | KeV | cm⁻² | KeV | cm⁻² | Depth | Conc. | D | G | Type | Ω/□ |
| 46 | 10 | 5.0×10¹³ | 30 | 7.0×10¹³ | 0.05 | 80 | Yes | No | *n* | 1.3×10⁶ |
| 47 | 60 | 3.0×10¹⁴ | 250 | 2.0×10¹⁴ | 0.25 | 170 | Yes | No | *n* | 1.5×10⁵ |
| 48 | 40 | 2.0×10¹⁵ | 150 | 1.0×10¹⁵ | 0.18 | 1180 | Yes | No | *n* | 2.8×10⁴ |
| 49 | 150 | 5.0×10¹⁴ | 250 | 1.0×10¹⁵ | 0.30 | 20 | Yes | No | *n* | 1.2×10⁶ |
| 50 | 20 | 4.0×10¹³ | 20 | 2.0×10¹⁵ | 0.06 | 15 | Yes | No | *n* | 8.6×10⁶ |
| 51 | 50 | 3.0×10¹⁵ | 200 | 1.0×10¹⁴ | 0.22 | 110 | Yes | No | *n* | 2.4×10⁵ |
| 52 | 40 | 2.0×10¹⁵ | - | - | - | - | Yes | No | *n* | 9.1×10¹⁰ |
| 53 | - | - | 100 | 3.0×10¹⁵ | - | - | Yes | No | *n* | 1.0×10¹³ |
| 54 | 150 | 5.0×10¹³ | 250 | 1.0×10¹⁴ | 0.30 | 2 | Yes | No | *n* | 8.6×10⁹ |
| 55 | 10 | 5.0×10¹² | 30 | 7.0×10¹² | 0.05 | 8 | Yes | No | *n* | 2.8×10⁹ |
| 56 | 40 | 2.0×10¹² | 150 | 1.0×10¹² | 0.16 | 1 | Yes | No | *n* | 1.6×10¹⁰ |
| 57 | 40 | 4.0×10¹⁵ | 100 | 2.0×10¹⁵ | 0.14 | 2000 | Yes | Yes | - | - |
| 58 | 80 | 1.0×10¹⁶ | 350 | 2.0×10¹⁶ | 0.27 | 7050 | Yes | Yes | - | - |

From Table III it may be ascertained that in the instances in which implantation was conducted at energies and doses such that implantation depths at which the *Li* and *N* ion concentrations each were 10 ppm or more would overlap, and in which the *Li* and *N* sum-total dose is 5.0 × 10¹⁵ cm⁻² or less, through the annealing process radiation damage was repaired and at the same time the *Li* and *N* were electrically activated, which formed low-resistivity *n*-type semiconductor diamond.

In contrast, in the instances in which either *Li* or *N* was implanted solo, and in which there was no lapping of regions where the *Li* and *N* concentrations each were 10 ppm or more, although the carrier type could be verified as *n*, the sheet resistance was larger than 1.0 × 10⁷ Ω/□, meaning that a workable resistance could not be achieved. In turn, in those samples in which the *Li* and *N* sum-total dose was in excess of 5.0 × 10¹⁵ cm⁻² through annealing that has been performed to date, the diamond's crystallinity did not recover itself completely and graphite components remained, wherein Hall-effect measurements could not be made.

### Comparative Example 3

*Li* and *Ar* ions were implanted in a manner similar to that of Embodiment 1, except that the implantation was done with the *Li* being rendered in a 40 keV implantation energy and 2.0 × 10¹⁵ cm⁻² dose, and the *Ar* being rendered in a 300 keV implantation energy and 1.0 × 10¹⁵ cm⁻² dose. The result was that in the concentration profiles for the *Li* and *Ar,* the lapping depth was 0.17 µm, where the concentration was 870 ppm. In the Raman spectral analysis only the 1333 cm⁻¹ peak appeared, confirming that the diamond's crystallinity was restored. Nevertheless, in the Hall-effect measurement, although it was determined that Comparative Example 3 was *n*-type, with its sheet resistance being an extraordinarily high 9.3 × 10¹⁰ Ω/□, the example did not prove to be a practicable *n*-type semiconductor diamond.

### Embodiment 4

An implanter featuring two ion-beam lines whose maximum acceleration voltage is 400 kV and an electron-beam line whose maximum acceleration voltage is 100 kV, capable of cooling to the temperature of liquid nitrogen (-196°C) and having a cooling/heating/implanting stage capable of ramping up from room temperature to 1400°C in approximately 10 seconds was utilized for the implantation of *Li* and *N* ions.

The same single-crystal diamond for ion implantation as in Embodiment 3 was utilized: a high-pressure/high-temperature synthesized type-I*b* single-crystal diamond (100), 2 mm × 2 mm × 0.3 mm, onto which 3 µm of high-quality undoped diamond was epitaxially grown. The implant tilt for preventing channeling of the implantation ions was put at 7° for both *Li and N.* The beam current for an electron beam with an energy of 50 keV was set so that the beam would equal the *Li* and *N* dose, and the diamond was irradiated with the electron beam at the same time it was doped with the *Li* and *N* ions. The temperature during implantation was -97°C. The annealing process and the post-implantation evaluation of the diamond were conducted likewise as with Embodiment 3. The *Li* and *N* implantation parameters and evaluation results are set forth in Table IV.

**Table IV**

| No. | Implantation parameters | | | | Evaluation results | | | | | |
|---|---|---|---|---|---|---|---|---|---|---|
| | Li | | N | | Li & N overlap | | Raman | | Hall meas. | |
| | KeV | cm⁻² | KeV | cm⁻² | Depth | Conc. | D | G | Type | Ω/□ |
| 59 | 10 | 5.0×10¹³ | 30 | 7.0×10¹³ | 0.05 | 80 | Yes | No | *n* | 1.1×10⁶ |
| 60 | 60 | 3.0×10¹⁴ | 250 | 2.0×10¹⁴ | 0.25 | 170 | Yes | No | *n* | 1.3×10⁵ |
| 61 | 40 | 2.0×10¹⁵ | 150 | 1.0×10¹⁵ | 0.18 | 1180 | Yes | No | *n* | 2.4×10⁴ |
| 62 | 150 | 5.0×10¹⁴ | 250 | 1.0×10¹⁵ | 0.30 | 20 | Yes | No | *n* | 1.0×10⁶ |
| 63 | 20 | 4.0×10¹³ | 20 | 2.0×10¹⁵ | 0.06 | 15 | Yes | No | *n* | 7.3×10⁶ |
| 64 | 50 | 3.0×10¹⁵ | 200 | 1.0×10¹⁴ | 0.22 | 110 | Yes | No | *n* | 2.0×10⁵ |
| 65 | 150 | 5.0×10¹³ | 250 | 1.0×10¹⁴ | 0.29 | 2 | Yes | No | *n* | 8.7×10⁹ |
| 66 | 10 | 5.0×10¹² | 30 | 7.0×10¹² | 0.05 | 8 | Yes | No | *n* | 2.6×10⁹ |
| 67 | 40 | 2.0×10¹² | 150 | 1.0×10¹² | 0.16 | 1 | Yes | No | *n* | 1.7×10¹⁰ |
| 68 | 40 | 4.0×10¹⁵ | 100 | 2.0×10¹⁵ | 0.14 | 2000 | Yes | Yes | - | - |
| 69 | 80 | 1.0×10¹⁶ | 350 | 2.0×10¹⁶ | 0.27 | 7050 | Yes | Yes | - | - |

From Table IV it may be ascertained that in the instances in which it was arranged so that the single-crystal diamond that underwent implantation was doped simultaneously with *Li* and *N* while being irradiated with an electron beam and implantation was conducted so that implantation depths at which the *Li* and *N* concentrations each were 10 ppm or more would overlap, and in which the ions were implanted with the *Li* and *N* sum-total dose being 5.0 × 10¹⁵ cm⁻² or less, by a traditional annealing process, the radiation damage was repaired and the *Li* and *N* were electrically activated; and compared to the instances in which *Li* and *N* ions were implanted simultaneously, yet electron-beam irradiation was not done, even lower resistivity *n*-type semiconductor diamond was formed.

In contrast, in the instances in which the regions where the Li and N concentrations each were 10 ppm or more did not overlap, although the carrier type could be verified as *n,* the sheet resistance was greater than 1.0 × 10⁷ Ω/□, meaning that a workable resistance could not be achieved. In turn, in those samples in which the *Li* and *N* sum-total dose was in excess of 5.0 × 10¹⁵ cm⁻², the diamond's crystallinity did not recover itself completely and graphite components remained, wherein Hall measurements could not be made.

### Comparative Example 4

*Li* and *Ar* ions were implanted in a manner similar to that of Embodiment 4, except that the implantation was done with the *Li* being rendered in a 40 keV implantation energy and 2.0 × 10¹⁵ cm⁻² dose, and the *Ar* being rendered in a 300 keV implantation energy and 1.0 × 10¹⁵ cm⁻² dose. The result was that in the concentration profiles for the *Li* and *Ar,* the lapping depth was 0.18 µm, where the concentration was 850 ppm. In the Raman spectral analysis only the 1333 cm⁻¹ peak appeared, confirming that the diamond's crystallinity was restored. Nevertheless, in the Hall-effect measurement, although it was determined that Comparative Example 4 was *n*-type, with its sheet resistance being a very high 9.5 × 10¹⁰ Ω/□, the example did not prove to be a practicable *n*-type semiconductor diamond.

### Embodiment 5

High-pressure/high-temperature synthesized type-II*a* diamond was chosen for the single-crystal diamond to be doped. The samples measured 2 mm × 2 mm, and were 0.3 mm in thickness. The 2 mm × 2 mm plane was rendered (100). The same ion-implantation and diamond evaluation as in Embodiment 1 were conducted, except for having the temperature parameter for implantation be room temperature (27°C) and the annealing parameters be 800°C or more but less than 1800°C, under a pressure of 3 GPa or more. The ion-implantation parameters and evaluation results are set forth in Table V, and the annealing parameters, in Table VI. Here, for annealing, an ultrahigh-pressure generator was utilized to pressurize the samples to a preselected pressure and subsequently heat them up to a preselected temperature. The anneal time was 10 hours.

**Table V**

| No. | Implantation parameters | | | | Evaluation results | | | | | |
|---|---|---|---|---|---|---|---|---|---|---|
| | Li | | N | | Li & N overlap | | Raman | | Hall meas. | |
| | KeV | cm⁻² | KeV | cm⁻² | Depth | Conc. | D | G | Type | Ω/□ |
| 70 | 30 | 4.0×10¹⁴ | 90 | 2.0×10¹⁴ | 0.12 | 300 | Yes | No | n | 1.6×10⁵ |
| 71 | 40 | 2.0×10¹⁵ | 100 | 2.0×10¹⁵ | 0.15 | 1200 | Yes | No | n | 3.8×10⁴ |
| 72 | 70 | 3.0×10¹⁵ | 300 | 4.0×10¹⁵ | 0.27 | 1600 | Yes | No | n | 1.4×10⁴ |
| 73 | 80 | 2.0×10¹⁶ | 350 | 3.0×10¹⁶ | 0.28 | 13900 | Yes | No | n | 1.5×10³ |
| 74 | 40 | 2.0×10¹⁵ | - | - | - | - | Yes | No | n | 8.9×10¹⁰ |
| 75 | - | - | 100 | 3.0×10¹⁵ | - | - | Yes | No | n | 1.0×10¹³ |
| 76 | 150 | 5.0×10¹³ | 250 | 1.0×10¹⁴ | 0.29 | 2 | Yes | No | n | 8.4×10⁹ |
| 77 | 10 | 5.0×10¹² | 30 | 7.0×10¹² | 0.05 | 8 | Yes | No | n | 2.7×10⁹ |
| 78 | 40 | 2.0×10¹² | 150 | 1.0×10¹² | 0.16 | 1 | Yes | No | n | 1.6×10¹⁰ |

**Table VI**

| No. | Temp. (°C) | Pressure (GPa) |
|---|---|---|
| 70 | 820 | 3.5 |
| 71 | 1750 | 6.5 |
| 72 | 1100 | 6.0 |
| 73 | 1450 | 7.9 |
| 74 | 1300 | 5.5 |
| 75 | 1000 | 6.7 |
| 76 | 850 | 4.0 |
| 77 | 1650 | 5.8 |
| 78 | 1200 | 7.3 |

As will be understood from Tables V and VI, by annealing the post-implantation diamond with the temperature parameter being 800°C or more but less than 1800°C, and under a pressure of 3 GPa or more, even in samples doped at a dose at which radiation damage would not be repaired by conventional annealing techniques, radiation damage was repaired and at the same time the *Li* and *N* were electrically activated, which verified that low-resistivity *n*-type semiconductor diamond was formed.

In contrast, in the instances in which either *Li* or *N* was implanted solo, and in which there was no lapping of regions where the Li and N concentrations each were 10 ppm or more, although the carrier type could be verified as *n*, the sheet resistance was 1.0 × 10⁷ Ω/□ or more, meaning that a practicable resistance could not be achieved.

### Comparative Example 5

*Li* and *Ar* ions were implanted in a manner similar to that of Embodiment 5, except that the implantation was done with the Li being rendered in a 40 keV implantation energy and 2.0 × 10¹⁵ cm⁻² dose, and the *Ar* being rendered in a 300 keV implantation energy and 1.0 × 10¹⁵ cm⁻² dose, and that the annealing parameters were put at 1000°C temperature and 6.7 GPa pressure. The result was that in the concentration profiles for the *Li* and *Ar,* the lapping depth was 0.17 µm, where the concentration was 880 ppm. In the Raman spectral analysis only the 1333 cm⁻¹ peak appeared, confirming that the diamond's crystallinity was restored. Nevertheless, in the Hall-effect measurement, although it was determined that Comparative Example 5 was *n*-type, with its sheet resistance being a very high 9.2 × 10¹⁰ Ω/□, the example did not prove to be a practicable *n*-type semiconductor diamond.

### Embodiment 6

Doped diamond was produced and evaluated in the same way as in Embodiment 5―with the *Li* and *N* ion-implantation parameters made the same as for Sample No. 73 in Table V―except for having the annealing conditions be the parameters set forth in Table VII.

**Table VII**

| No. | Annealing parameters | | Evaluation results | | | | | |
|---|---|---|---|---|---|---|---|---|
| | Temp. (°C) | Press. (GPa) | Li & N overlap | | Raman | | Hall meas. | |
| | | | Depth | Conc. | D | G | Type | Ω/□ |
| 73 | 1450 | 7.9 | 0.28 | 13900 | Yes | No | *n* | 1.5x10³ |
| 79 | 780 | 2.5 | 0.28 | 13900 | Yes | Yes | - | - |
| 80 | 780 | 4.8 | 0.28 | 13900 | Yes | Yes | - | - |
| 81 | 1000 | 2.5 | 0.28 | 13900 | Yes | Yes | - | - |
| 82 | 1900 | 2.5 | 0.28 | 13900 | Yes | Yes | - | - |
| 83 | 1900 | 4.8 | 0.28 | 13900 | Yes | Yes | - | - |

As will be understood from Table VII, in temperature ranges less than 800°C and over 1800°C, peaks at 1500 cm⁻¹ to 1600 cm⁻¹ appeared in Raman spectral analysis, with the crystallinity not recovering itself. Likewise, even within a temperature range of from 800°C to less than 1800°C, at a pressure of less than 3 GPa, the crystallinity was not restored.

### Embodiment 7

An implanter featuring two ion-beam lines whose maximum acceleration voltage is 400 kV and an electron-beam line whose maximum acceleration voltage is 100 kV, capable of cooling to the temperature of liquid nitrogen (-196°C) and having a cooling/heating/implanting stage capable of ramping up from room temperature to 1400°C in approximately 10 seconds was utilized for the implantation of *Li* and *N* ions.

High-pressure/high-temperature synthesized type-II*a* diamond was chosen for the single-crystal diamond to be doped. The samples measured 2 mm × 2 mm, and were 0.3 mm in thickness. The 2 mm × 2 mm plane was rendered (100). The temperature parameter for implantation was put at -97°C, and employing the two ion-beam lines, the *Li* and *N* ions were implanted simultaneously. The implant tilt for preventing channeling was put at 7° for both *Li* and *N*, and the beam current for an electron beam with an energy of 50 keV was set so that the beam would equal the *Li* and *N* sum-total dose, and the diamond was irradiated at the same time it was doped with the *Li* and *N* ions.

The same ion-implantation and diamond evaluation as in Embodiment 3 were conducted, except for having the annealing parameters be 800°C or more but less than 1800°C, under a pressure of 3 GPa or more. The ion-implantation parameters and evaluation results are set forth in Table VIII, and the annealing parameters, in Table IX. Here, for annealing, an ultrahigh-pressure generator was utilized to pressurize the samples to a preselected pressure and subsequently heat them up to a preselected temperature. The anneal time was 10 hours.

**Table VIII**

| No. | Implantation parameters | | | | Evaluation results | | | | | |
|---|---|---|---|---|---|---|---|---|---|---|
| | Li | | N | | Li & N overlap | | Raman | | Hall meas. | |
| | KeV | cm⁻² | KeV | cm⁻² | Depth | Conc. | D | G | Type | Ω/□ |
| 84 | 30 | 4.0×10¹⁴ | 90 | 2.0×10¹⁴ | 0.12 | 300 | Yes | No | *n* | 1.3×10⁵ |
| 85 | 40 | 2.0×10¹⁵ | 100 | 2.0×10¹⁵ | 0.15 | 1200 | Yes | No | *n* | 3.2×10⁴ |
| 86 | 70 | 3.0×10¹⁵ | 300 | 4.0×10¹⁵ | 0.27 | 1600 | Yes | No | *n* | 1.1×10⁴ |
| 87 | 80 | 2.0×10¹⁶ | 350 | 3.0×10¹⁶ | 0.28 | 13900 | Yes | No | *n* | 1.2×10³ |
| 88 | 150 | 5.0×10¹³ | 250 | 1.0×10¹⁴ | 0.29 | 2 | Yes | No | *n* | 8.5×10⁹ |
| 89 | 10 | 5.0×10¹² | 30 | 7.0×10¹² | 0.05 | 8 | Yes | No | *n* | 2.6×10⁹ |
| 90 | 40 | 2.0×10¹² | 150 | 1.0×10¹² | 0.16 | 1 | Yes | No | *n* | 1.5×10¹⁰ |

**Table IX**

| No. | Temp. (°C) | Pressure (GPa) |
|---|---|---|
| 84 | 820 | 3.5 |
| 85 | 1750 | 6.5 |
| 86 | 1100 | 6.0 |
| 87 | 1450 | 7.9 |
| 88 | 850 | 4.0 |
| 89 | 1650 | 5.8 |
| 90 | 1200 | 7.3 |

As will be understood from Tables VIII and IX, by doping while irradiating with an electron beam the implantation-subjected diamond simultaneously with *Li* and *N* ions so that implantation depths at which the *Li* and *N* concentrations each were 10 ppm or more would overlap, with the temperature parameter being 800°C or more but less than 1800°C, even in samples doped at a dose at which radiation damage would not be repaired by conventional annealing techniques, radiation damage was repaired and at the same time the *Li* and *N* were electrically activated, which verified that compared to the instances in which *Li* and *N* ions were implanted simultaneously, yet electron-beam irradiation was not done, even lower resistivity *n*-type semiconductor diamond was formed.

In contrast, in the instances in which the regions where the *Li* and *N* concentrations each were 10 ppm or more did not overlap, although the carrier type could be verified as *n*, the sheet resistance was greater than 1.0 × 10⁷ Ω/□, meaning that a workable resistance could not be achieved.

### Comparative Example 7

*Li* and *Ar* ions were implanted in a manner similar to that of Embodiment 7, except that the implantation was done with the *Li* being rendered in a 40 keV implantation energy and 2.0 × 10¹⁵ cm⁻² dose, and the *Ar* being rendered in a 300 keV implantation energy and 1.0 × 10¹⁵ cm⁻² dose, and that the annealing parameters were put at 1200°C temperature and 6.0 GPa pressure. The result was that in the concentration profiles for the Li and *Ar,* the lapping depth was 0.16 µm, where the concentration was 890 ppm. In the Raman spectral analysis only the 1333 cm⁻¹ peak appeared, confirming that the diamond's crystallinity was restored. Nevertheless, in the Hall-effect measurement, although it was determined that Comparative Example 7 was *n*-type, with its sheet resistance being a very high 9.0 × 10¹⁰ Ω/□, the example did not prove to be a practicable *n*-type semiconductor diamond.

### Embodiment 8

Doped diamond was produced and evaluated in the same way as in Embodiment 5―with the *Li* and *N* ion-implantation parameters made the same as for Sample No. 87 in Table VIII―except for having the annealing conditions be the parameters set forth in Table X.

**Table X**

| No. | Annealing parameters | | Evaluation results | | | | | |
|---|---|---|---|---|---|---|---|---|
| | Temp. (°C) | Press. (GPa) | Li & N overlap | | Raman | | Hall meas. | |
| | | | Depth | Conc. | D | G | Type | Ω/□ |
| 87 | 1450 | 7.9 | 0.28 | 13900 | Yes | No | n | 1.2×10³ |
| 91 | 780 | 2.5 | 0.28 | 13900 | Yes | Yes | - | - |
| 92 | 780 | 4.8 | 0.28 | 13900 | Yes | Yes | - | - |
| 93 | 1000 | 2.5 | 0.28 | 13900 | Yes | Yes | - | - |
| 94 | 1900 | 2.5 | 0.28 | 13900 | Yes | Yes | - | - |
| 95 | 1900 | 4.8 | 0.28 | 13900 | Yes | Yes | - | - |

As will be understood from Table IX, in temperature ranges less than 800°C and over 1800°C, peaks at 1500 cm⁻¹ to 1600 cm⁻¹ appeared in Raman spectral analysis, with the crystallinity not recovering itself. Likewise, even within a temperature range of from 800°C to less than 1800°C, at a pressure of less than 3 GPa, the crystallinity was not restored.

### Industrial Applicability

In accordance with a method of manufacturing *n*-type semiconductor diamond by the present invention using the ion implantation method to incorporate *Li* and *N* into single-crystal diamond, and annealing the diamond within a predetermined temperature range to electrically activate the *Li* and *N* and restore the diamond crystalline structure makes it possible to produce low-resistivity *n*-type semiconductor diamond.

Inasmuch as such *n*-type semiconductor diamond has superior semiconductor properties, its practical application is enabled as a material for semiconductor devices such as harsh-environment-withstanding devices that operate under high-temperature environments and outer-space environments; power devices that can operate at high frequency and with high-output; light-emitting devices capable of emitting ultraviolet light; and electron emitters that can be driven at low voltage.

## Claims

1. A method of manufacturing *n*-type semiconductor diamond, **characterized in** having a step of producing diamond incorporating *Li* and *N* by implanting *Li* ions into, so that 10 ppm thereof will be contained in, single-crystal diamond incorporating 10 ppm or more *N,* and a step of annealing said diamond incorporating *Li* and *N* at a temperature in range of from 800°C to less than 1800°C.

2. A method of manufacturing *n*-type semiconductor diamond, **characterized in** having a step of producing diamond incorporating *Li* and *N* by implanting into single-crystal diamond essentially not containing impurities *Li* and *N* ions, and so that ion-implantation depths at which the post-implantation *Li* and *N* concentrations each are 10 ppm or more will overlap, and a step of annealing said diamond incorporating *Li* and *N at* a temperature in range of from 800°C to less than 1800°C.

3. A method of manufacturing *n*-type semiconductor diamond in which *Li* and *N* ions are implanted into single-crystal diamond, the *n*-type semiconductor-diamond manufacturing method **characterized in that** the ions are implanted so that ion-implantation depths at which the post-implantation *Li* and *N* concentrations each are 10 ppm or more will overlap, and so that the *Li* and *N* sum-total dose is 5.0 × 10¹⁵ cm⁻² or less.

4. An *n*-type semiconductor-diamond manufacturing method as set forth in claim 3, **characterized in that** an ion-implantation apparatus having an electron-beam line and two ion-beam lines is utilized to implant the *Li* and *N* ions simultaneously while radiating with the electron beam the single-crystal diamond that is ion-implanted.

5. A method of manufacturing *n*-type semiconductor diamond, **characterized in** annealing post-implantation diamond at a temperature in range of from 800°C to less than 1800°C, under high-pressure conditions of 3 GPa or more.

6. Semiconductor diamond being *n*-type, **characterized in** incorporating, from a crystal face thereof to the same depth, 10 ppm or more of each of *Li* and *N,* and **in that** its sheet resistance is 10⁷ Ω/□ or less.
